# FASCICULE DE BREVET EUROPEEN

(11) **EP 2 263 969 B1**
(45) Date de publication et mention de la délivrance du brevet: **06.12.2017**
(21) Numéro de dépôt: 10165192.5
(22) Date de dépôt: 08.06.2010
(51) Int. Cl.: B81C 1/00

(54) **Procédé de libération amelioré de la structure suspendue d'un composant NEMS et/ou MEMS**
Verbessertes Freigabeverfahren der hängenden Struktur eines nanoelektronischen und/oder mikroelektronischen Bauteils
Improved release method for the suspended structure of a NEMS and/or MEMS component

(30) Priorité: 15.06.2009 FR 0953976
(43) Date de publication de la demande: 22.12.2010
(73) Titulaire: Commissariat à l'Énergie Atomique et aux Énergies Alternatives, 75015 Paris (FR)
(72) Inventeur: Dupre, Cécilia, 76240 BONSECOURS (FR); Robert, Philippe, 38000 GRENOBLE (FR)
(74) Mandataire: Ilgart, Jean-Christophe

(56) Documents cités:
- EP-A- 2 043 141
- US-A1- 2004 209 435
- US-A1- 2004 248 344
- US-A1- 2005 271 324
- US-A1- 2006 148 133
- US-A1- 2007 072 327

## Description

### DOMAINE TECHNIQUE

La présente invention concerne le domaine de la microélectronique et notamment celui des dispositifs dotés d'au moins un composant électromécanique tel qu'un NEMS (NEMS pour « Nano Electro Mechanical Systems ») et/ou un MEMS (MEMS pour « Micro Electro Mechanical Systems ».

Elle prévoit un procédé amélioré de libération d'une structure suspendue d'un composant électromécanique et peut permettre de réaliser une structure suspendue, de détection, éventuellement mobile, et qui est entourée d'une couche de passivation lors de sa libération finale.

L'invention s'applique à la réalisation d'un dispositif microélectronique doté d'au moins un composant électro-mécanique et d'un ou plusieurs transistors.

### ART ANTÉRIEUR

Le document US 2006/0148133 A1 présente un procédé de réalisation d'un dispositif MEMS comprenant un composant électromécanique à structure suspendue.

Le document US 2005/0271324 A1 prévoit un procédé de réalisation d'un dispositif optoélectronique à structure suspendue.

Il est connu de vouloir co-intégrer sur un même substrat, une structure de NEMS et/ou de MEMS avec un ou plusieurs transistors. Il existe plusieurs possibilités de co-intégration.

Une première possibilité consiste à réaliser un composant NEMS et un transistor MOS séparément.

Une deuxième possibilité consiste à réaliser un composant doté à la fois d'une structure mobile NEMS et qui peut remplir la fonction d'un transistor.

Cette deuxième possibilité est décrite par exemple dans le document *:"*Vibrating-Body Field Effect Transistor (VB-FETs)", Grogg et al., IEEE International Electron Devices Meeting IEDM, p. 663, 2008.

La réalisation d'un dispositif microélectronique doté d'un composant NEMS et/ou MEMS, doté d'une structure semi-conductrice mobile sous forme d'un barreau semi-conducteur, pose problème, notamment lors de la réalisation d'une passivation de ce barreau semi-conducteur, et lorsqu'on effectue une libération de ce dernier.

On peut chercher à conserver une épaisseur de matériau diélectrique autour de la structure mobile d'un composant MEMS, pour former une couche de protection provisoire au cours de la fabrication du composant, et/ou pour former une couche de passivation définitive, ou éventuellement former une couche de passivation jouant le rôle d'oxyde de grille.

Une couche de passivation permet notamment d'assurer une stabilité en résistance du barreau semi-conducteur.

Il est difficile de conserver une couche de matériau diélectrique tel que du SiO₂ autour du barreau semi-conducteur destiné à former la structure mobile d'un composant électromécanique, après l'étape de libération de ce dernier. Ce barreau semi-conducteur, est en effet généralement libéré par gravure d'une couche sacrificielle de matériau diélectrique sur laquelle ce barreau semi-conducteur repose, et qui peut être également à base de SiO₂.

Une réalisation ultérieure de la couche de matériau diélectrique après l'étape de libération, pose également problème, en particulier lorsque cette étape de libération est réalisée à la fin des étapes dites de « back end ».

Pour réaliser une épaisseur diélectrique autour d'un barreau semi-conducteur par oxydation de ce dernier, un budget thermique important est en effet nécessaire, ce qui serait incompatible avec la présence de contacts métalliques et d'interconnexions métalliques formées lors des étapes de back end.

Lorsqu'on réalise un dispositif microélectronique doté d'un composant électro-mécanique MEMS ou NEMS, co-intégré avec un transistor, la libération de la structure mobile du composant électro-mécanique du barreau semi-conducteur est généralement réalisée lors des étapes de « Back-end », une fois que les niveaux d'interconnexions ont été réalisés.

Cette libération peut avoir tendance à dégrader dans le même temps les couches isolantes dans lesquelles les niveaux métalliques d'interconnexion sont formés.

Il se pose le problème de trouver un nouveau procédé de libération de la structure mobile d'un composant électro-mécanique MEMS ou NEMS, qui ne comporte pas les inconvénients évoqués ci-dessus.

### EXPOSÉ DE L'INVENTION

L'invention propose un procédé de réalisation d'un dispositif microélectronique comprenant, au moins un composant, électro-mécanique ou électronique doté d'une structure suspendue, le procédé comprenant les étapes consistant à :
a) former sur une couche de support, au moins un élément rattaché à au moins un bloc d'ancrage dans au moins une couche mince disposée sur la couche de support, ledit élément étant destiné à former ladite structure suspendue du composant électro-mécanique ou électronique,
b) retrait d'une portion de la couche de support au moins sous ledit élément, de manière à libérer la structure suspendue,
c) formation d'une couche de passivation autour dudit élément,
d) formation d'une couche d'encapsulation recouvrant ladite couche de passivation et ledit élément, la couche d'encapsulation étant à base d'un matériau apte à être gravé de manière sélective vis-à-vis du matériau de la couche de passivation,
les couches de passivation et d'encapsulation étant formées de manière à recouvrir la couche mince, et le procédé comprenant en outre, après l'étape d), des étapes de :
- retrait de portions de la couche d'encapsulation, de manière à dévoiler une zone donnée de ladite couche mince,
- formation d'une couche de protection de la couche d'encapsulation,
- retrait partiel de la couche de protection et de la couche de passivation de manière à dévoiler au moins ladite zone donnée de ladite couche mince,
- formation d'au moins un transistor à partir de ladite zone donnée de ladite couche mince,
- réalisation de zones conductrices de contact et/ou d'interconnexion, puis
- suppression de la couche d'encapsulation autour dudit élément de manière sélective vis-à-vis de la couche de passivation, libérant à nouveau ladite structure suspendue.

L'élément destiné à former ladite structure suspendue peut être par exemple sous forme d'un barreau, ou d'un fil, ou d'une poutre, ou de plusieurs barreaux, ou de plusieurs fils, ou de plusieurs poutres formant par exemple un motif de peigne.

La structure suspendue peut être une structure de détection.

La structure suspendue peut être par exemple une structure de détection dont on mesure la conductance, telle qu'une structure suspendue de transistor.

Dans le cas où le composant est un composant électromécanique MEMS et/ou NEMS, la structure suspendue peut être mobile et destinée à se déplacer.

La structure suspendue peut être par exemple une structure vibrante d'un résonateur.

La composition dudit élément peut dépendre de l'application visée et peut être semi-conductrice, par exemple à base de Si ou de SiGe.

La couche d'encapsulation et la couche de support sont à base de matériaux différents.

La couche d'encapsulation et la couche de passivation sont également à base de matériaux différents.

La couche d'encapsulation peut être à base d'un matériau apte à être gravé de manière sélective vis-à-vis du matériau diélectrique de la couche de passivation.

On peut ainsi réaliser une libération de la structure mobile en deux temps, et protéger une couche de passivation réalisée préalablement à la réalisation de contacts et d'interconnexions des composants du dispositif microélectronique.

La couche de passivation peut être formée par oxydation dudit élément lorsque ce dernier est à base de semi-conducteur.

Selon une variante, la couche de passivation peut être formée par dépôt.

Selon une possibilité de mise en oeuvre, la couche d'encapsulation est à base de polysilicium ou de silicium amorphe ou SiGe ou de Si.

Selon une possibilité de mise en oeuvre, la couche de passivation est à base de SiO₂ ou de SiₓN_{y}.

Selon une possibilité de mise en oeuvre, l'étape a) peut comprendre la réalisation dudit élément, par exemple sous forme d'au moins un barreau et de ses blocs d'ancrage dans au moins une couche mince disposée sur le support.

Le procédé peut comprendre en outre, après l'étape d) et préalablement à la réalisation des zones conductrices de contact et/ou d'interconnexion, la formation d'au moins un transistor à partir d'une zone donnée de ladite couche mince.

Les couches de passivation et d'encapsulation peuvent être formées de manière à recouvrir la couche mince.

Dans ce cas, le procédé peut comprendre en outre, préalablement à la formation dudit transistor, les étapes de :
- retrait de portions de la couche d'encapsulation, de manière à dévoiler ladite zone donnée de ladite couche mince,
- formation d'une couche de protection de la couche d'encapsulation,
- retrait partiel de la couche de protection et de la couche de passivation de manière à dévoiler au moins ladite zone donnée de ladite couche mince.

Le retrait de portions de la couche d'encapsulation peut comprendre la formation d'une ou plusieurs ouvertures au dessus respectivement d'un ou plusieurs blocs d'ancrages dudit élément, ledit retrait de la couche de protection et de la couche de passivation étant réalisé de manière dévoiler les dits blocs d'ancrages, le procédé comprenant en outre la formation de contacts sur les dits blocs d'ancrage.

Lors de la formation de contacts sur les dits blocs d'ancrage, une pluralité de contacts du transistor peut être réalisée.

Selon une possibilité, ladite couche mince et la couche de support peuvent être des couches d'un substrat semi-conducteur sur isolant tel qu'un substrat SOI, la couche mince étant semi-conductrice et la couche support étant isolante.

La réalisation de zones conductrices comprend la formation d'un empilement d'un ou plusieurs niveaux métalliques d'interconnexion de composants du dispositif microélectronique et d'une ou plusieurs couches isolantes, ledit empilement recouvrant ledit composant électro-mécanique, le procédé comprenant en outre :
- la formation d'un trou dans ledit empilement en regard de l'élément et dévoilant la couche d'encapsulation,
ladite suppression de la couche d'encapsulation autour dudit élément étant réalisée par gravure de la couche d'encapsulation à travers ledit trou.

La suppression de la couche d'encapsulation autour dudit élément peut être réalisée par gravure à l'aide de XeF₂.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- les figures 1A à 1G illustrent un exemple de procédé de réalisation d'un dispositif microélectronique doté d'un composant comportant une structure suspendue semi-conductrice mobile et/ou de détection, entourée d'une couche de passivation,
- les figures 2A à 2F illustrent un exemple de procédé suivant l'invention de réalisation d'un dispositif microélectronique doté d'un composant comportant une structure suspendue semi-conductrice mobile et/ou de détection entourée d'une couche de passivation, co-intégré avec un transistor formé à partir de la même couche semi-conductrice que la structure vibrante,
- les figures 3A-3B, 4, 5A-5B illustrent un exemple de procédé de libération d'une structure mobile d'un composant électromécanique formé d'un barreau semi-conducteur entouré d'une couche de passivation,
- les figures 6A-6B illustrent un exemple de composant qui peut être obtenu à l'aide d'un procédé suivant l'invention et qui est doté d'une structure suspendue semi-conductrice formée d'un barreau semi-conducteur reliant une zone de source et une zone de drain et situé entre deux grilles.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

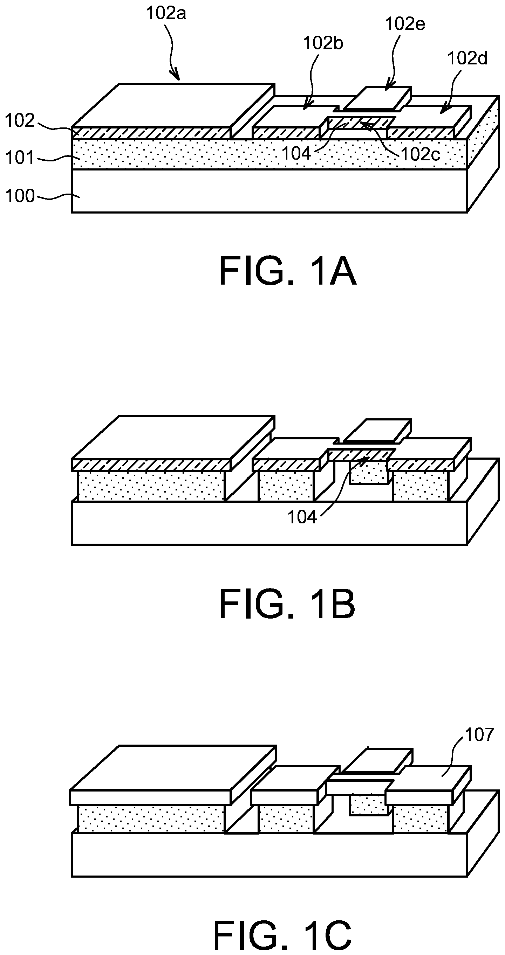

Un exemple de réalisation d'un dispositif microélectronique, va à présent être décrit en liaison avec les figures 1A-1G.

Le matériau de départ du procédé peut être un substrat de type semi-conducteur sur isolant, par exemple de type SOI (SOI pour « Silicon On Insulator » ou « silicium sur isolant »), comprenant une première couche 100 semi-conductrice, une couche isolante 101 par exemple d'oxyde enterré, et une couche mince semi-conductrice 102 reposant sur la couche d'oxyde enterré.

Dans la couche mince semi-conductrice 102, on forme des motifs 102a, 102b, 102c, 102d, 102e, par exemple par gravure telle qu'une gravure plasma sèche.

Parmi les motifs 102a, 102b, 102c, 102d, 102e formés, au moins un motif 102a de zone active de transistor peut être défini, tandis que des motifs d'électrodes 102b, 102c, 102d, d'un composant MEMS ou NEMS et au moins un motif 102c destiné à former une structure suspendue de détection et/ou mobile, de ce composant sont réalisés (figure 1A).

Le motif 102c de ladite structure est dans cet exemple sous forme d'un barreau semi-conducteur 104 de dimension critique de l'ordre du nanomètre ou de plusieurs dizaines de nanomètres dans le cas d'un composant NEMS ou de dimension critique de l'ordre du micromètre ou de plusieurs dizaines de micromètres dans le cas d'un composant MEMS.

Ensuite, on effectue un retrait de certaines parties de la couche 101, de manière à libérer le barreau 104 de son support.

Ce retrait partiel de la couche isolante 101 peut être effectué par gravure à l'aide par exemple de HF, de manière à conserver des blocs de la couche isolante 101 respectivement sous les zones 102a, 102b, 102d, 102e de la fine couche semi-conductrice 102. La structure 102c, qui dans cet exemple, est sous forme d'un barreau 104, est quant à elle libérée de la couche isolante 101 (figure 1B).

Ensuite, après cette première étape de libération de la structure, on effectue une passivation du barreau semi-conducteur 104. On forme pour cela une couche isolante 107, recouvrant notamment ce barreau semi-conducteur 104. Cette couche isolante 107, est formée de manière à entourer le barreau et peut être réalisée par exemple par oxydation du matériau semi-conducteur de la fine couche semi-conductrice 102, et en particulier du barreau semi-conducteur 104. Un oxyde « thermique » ou formé à haute température peut être réalisé.

Selon une autre possibilité, la couche isolante 107 de passivation peut être réalisée par exemple par dépôt de matériau diélectrique, tel que par exemple du SiₓN_{y} (figure 1C).

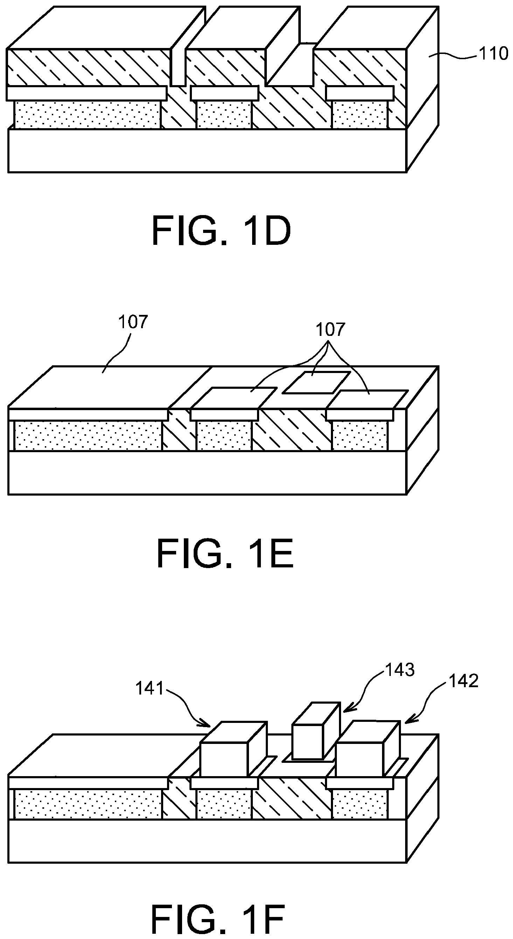

Ensuite, on forme une couche d'encapsulation 110, de manière à entourer le barreau semi-conducteur 104. La couche d'encapsulation 110 peut être réalisée de manière à recouvrir les motifs 102a, 102b, 102c, 102d, 102e, et combler certaines parties de la couche 101 qui ont été retirées (figure 1D).

La couche d'encapsulation 110 est à base d'un matériau choisi de sorte qu'il peut être gravé sélectivement vis-à-vis du matériau de la couche de passivation 107.

La couche d'encapsulation 110 peut être à base d'un matériau semi-conducteur, par exemple à base de polySi ou de Si amorphe.

On peut réaliser ensuite un polissage mécano-chimique (CMP) de la couche d'encapsulation 110, de manière à rendre plane la surface de cette dernière.

Puis, on effectue un retrait de la couche d'encapsulation 110, de manière à dévoiler la couche de passivation 107 au dessus des motifs 102a, 102b, 102e, 102d (figure 1E).

Ce retrait peut être effectué par exemple par gravure sèche de la couche d'encapsulation 110 sélective par rapport au matériau de la couche de passivation 107.

On peut ensuite réaliser une gravure des zones de la couche de passivation 107 dévoilées lors du retrait partiel de la couche d'encapsulation 110 effectué précédemment. Ce retrait peut être réalisé par désoxydation de la couche de passivation, par exemple en effectuant au préalable une photolithographie de manière à définir un masquage (non représenté) puis en réalisant une gravure sélective de la couche de passivation 107 à travers ce masquage, à l'aide par exemple d'une gravure humide à base de HF.

On forme ensuite des plots 141, 142, 143 à base d'un matériau conducteur, respectivement sur les motifs 102b, 102d, 102e, de manière à réaliser des contacts du composant MEMS/NEMS (figure 1F). Cela peut être réalisé par exemple par dépôt d'un matériau métallique tel que par exemple de l'Aluminium, puis gravure de ce matériau métallique.

On retire ensuite la couche d'encapsulation 110, par gravure sélective vis-à-vis de la couche de passivation 107 et des plots 141, 142, 143, de contact.

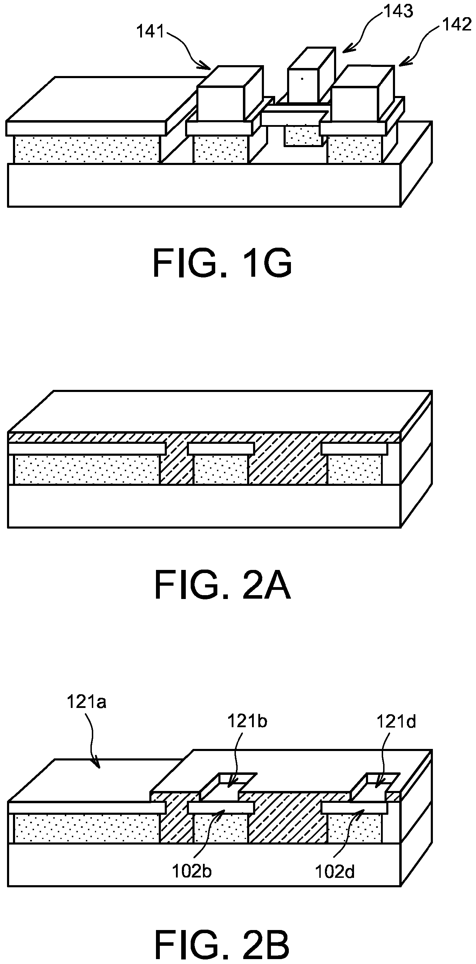

Un retrait de la couche d'encapsulation 110, autour du barreau 104, permet de libérer à nouveau ce dernier. La gravure sélective peut être effectuée par exemple à l'aide de gaz XeF₂ (figure 1G).

Par rapport à l'exemple de procédé qui vient d'être donné, on peut également former un transistor à partir du motif 102a, préalablement à la réalisation des plots de contacts 141, 142, 143.

Après une étape de polissage de la couche d'encapsulation 110 (figure 2A), on peut réaliser dans la couche d'encapsulation 110 des ouvertures 121b, 121d dévoilant des motifs 102b, 102d du composant électro-mécanique, et une ouverture 121a dévoilant le motif 102a de zone active (figure 2B).

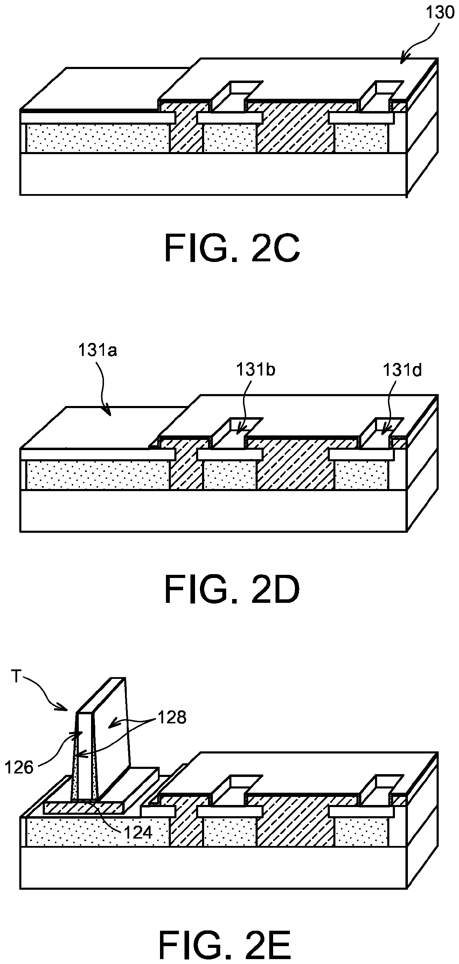

On forme ensuite une couche 130 de protection de la couche d'encapsulation 110, par exemple une couche d'oxyde de silicium HTO (HTO pour « High Thermal Oxide » selon la terminologie anglo-saxonne) (figure 2C). De manière générale, cette couche de protection 130 peut être constituée d'oxyde ou de tout autre matériau permettant de jouer un rôle d'arrêt à la gravure de la couche d'encapsulation 110.

Puis, en regard du motif 102a de la zone active et des motifs 102b, 102d d'électrodes du composant électro-mécanique, on retire cette couche 130 de protection ainsi que la couche 107 de passivation. Ce retrait peut être effectué par exemple à l'aide d'une étape de photolithographie et de gravure humide à base de HF. Des ouvertures 131a, 131b, 131d dévoilant respectivement les motifs 102a, 102b, et 102d de la fine couche semi-conductrice 102 sont ainsi réalisés (figure 2D). Cette gravure partielle de la couche de protection 130 permet donc d'accéder à la zone semi-conductrice qui va servir par la suite à la réalisation d'un transistor (au niveau de l'ouverture 131a), ainsi qu'aux zones qui vont permettre de reprendre un contact électrique sur les différentes électrodes du composant (au niveau des ouvertures 131b et 131d).

Cette couche de protection 130 permet notamment d'isoler, d'un point de vue procédé, la zone sur laquelle est réalisé le contact électrique (correspondant aux motifs 102b et 102d dans l'exemple décrit ici) de la couche d'encapsulation 110 qui est par exemple à base de poly-silicium. Ainsi, il est possible d'éviter toute incompatibilité d'un ou plusieurs matériaux qui constituent le contact (par exemple : NiSi, Ti, TiN, W , etc.) avec des éléments utilisés pour la gravure de la couche d'encapsulation 110 (exemple de type XeF₂, CF₄, etc.), évitant ainsi toute détérioration du fonctionnement électrique du composant à structure suspendue.

Ensuite, on forme un transistor T à partir du motif 102a.

Des étapes de gravure du motif 102a, de dopage de ce dernier, de formation d'une zone 124 de diélectrique de grille, de formation d'une grille 126, de formation d'espaceurs 128 de part et d'autre de cette grille 126, peuvent être réalisées (figure 2E).

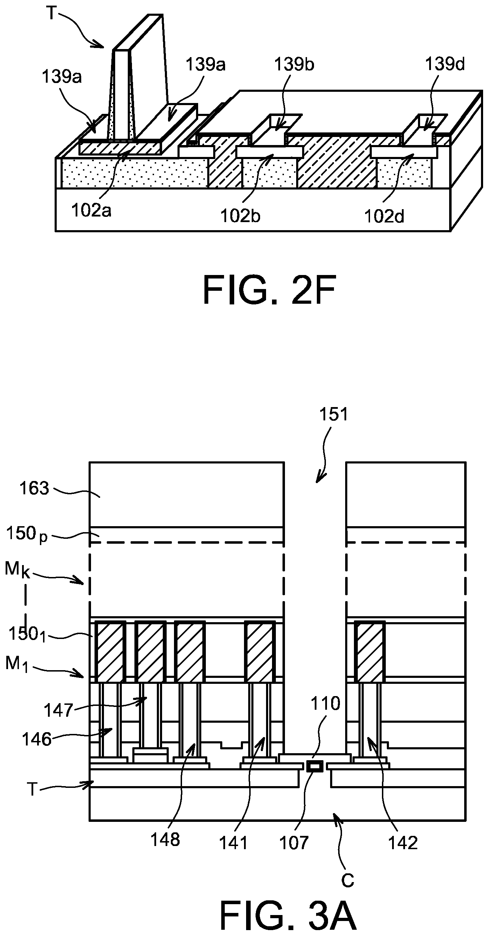

Des zones de contacts siliciurées 139a, 139b, 139d peuvent être ensuite formées respectivement sur les motifs 102a, 102b, 102d, à travers les ouvertures 131a, 131b, 131d, par siliciuration des zones de la fine couche semi-conductrice 102 qui sont dévoilées (figure 2F).

Ensuite, une fois les étapes communément appelées de « front end », on réalise des étapes dites « de back end » lors desquelles on forme un ou plusieurs niveaux métalliques d'interconnexion M₁,...,Mₖ dans un empilement de plusieurs couches isolantes 150₁,..., 150ₚ au dessus du transistor T et du composant électro-mécanique C.

L'empilement de couche isolantes 1501,...,150p peuvent, comprendre par exemple des couches de TEOS d'Oxyde de Silicium dopé au phosphore communément appelé PSG (PSG pour « Phosphore Doped Silicon Glass »), d'oxyde de SiH₄.

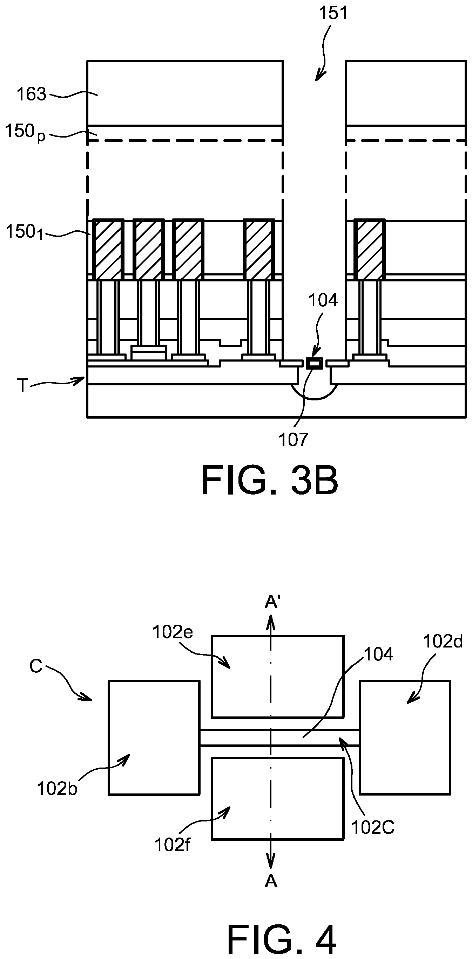

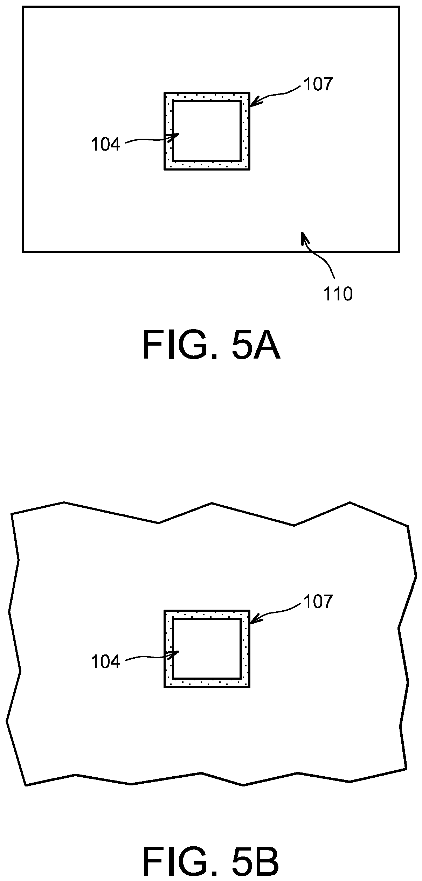

On forme ensuite au moins un trou 151 (figures 3A et 5A) dévoilant au moins une partie du composant C électro-mécanique recouvert par la couche d'encapsulation 110 (le dispositif en cours de réalisation étant représenté sur la figure 3A, selon une vue en coupe A'A indiquée sur la figure 4, laquelle représente le composant C en vue de dessus). Ce trou 151 peut être formé par gravure sèche anisotrope à travers un masquage 163, par exemple à base de résine. Si la couche de protection 130 est à base d'oxyde, il est possible que cette couche de protection 130 soit automatiquement gravée lors de la réalisation du trou 151, ne gênant pas la gravure ultérieure de la couche d'encapsulation. Dans le cas contraire, on peut prévoir étape de gravure spécifique de la couche de protection 130.

Puis, à travers le trou 151 traversant les couches isolantes 150₁,..., 150ₚ on effectue un retrait de la couche d'encapsulation 110 de manière à libérer la structure de détection et/ou de d'actionnement 102c du composant C électromécanique MEMS ou NEMS. On retire ainsi la couche d'encapsulation 110 autour du barreau 104.

La couche d'encapsulation 110 qui a servi de couche sacrificielle peut être retirée par gravure sélective vis-à-vis du matériau de la couche de passivation 107.

La gravure peut être réalisée à l'aide de XeF₂, notamment dans le cas où le matériau de la couche d'encapsulation 110 est du Si amorphe ou du polysilicium et que la couche de passivation est à base d'oxyde de silicium.

A l'issu de cette étape de libération du barreau semi-conducteur 104, celui-ci peut être maintenu suspendu au dessus du substrat par l'intermédiaire d'un ou plusieurs blocs formés dans la fine couche semi-conductrice 102. Le barreau semi-conducteur 104 peut être entouré du matériau diélectrique de la couche de passivation 107 (figures 3B et 5B).

On a ainsi libéré le barreau semi-conducteur 104 en gravant la couche d'encapsulation 110 qui est à base d'un matériau différent de celui des couches isolantes 150₁,..., 150ₚ et de celui de la couche isolante 101 de support. Une gravure sélective du matériau de la couche d'encapsulation 110 vis-à-vis des couches 150₁,..., 150ₚ, et 101 à base de matériau diélectrique permet de libérer le barreau semi-conducteur 104, sans altérer ces couches ni créer d'éventuels résidus néfastes de matériau diélectrique.

La couche de passivation 107 peut être ensuite conservée.

Cela peut permettre par exemple de conserver une résistance électrique stable du barreau semi-conducteur 104.

Dans le cas où la couche de passivation est formée d'un oxyde thermique de faible coefficient thermique de dilatation, cette couche de passivation permet de diminuer ou d'annuler le coefficient thermique de la structure.

Une couche de passivation 107 conservée autour du barreau 104 peut permettre par exemple de former un résonateur composé d'un barreau semi-conducteur, par exemple à base de Si entouré d'un diélectrique, par exemple de SiO₂. Un tel agencement peut permettre d'obtenir une meilleure stabilité de la fréquence de résonance avec la température.

Selon une variante de l'un ou l'autre des exemples de procédé qui ont été décrits, la structure suspendue, qui, dans les exemples donnés précédemment est sous forme d'un barreau, peut être réalisée après son bloc d'ancrage ou ses blocs d'ancrage.

Dans ce cas, les blocs d'ancrages peuvent être par exemple réalisés dans la couche semi-conductrice 102, tandis que l'élément 104 peut être formé par dépôt et gravure dans une autre couche, par exemple une couche de PolySi ou de PolySiGe ou par croissance d'un nanotube ou d'un nanofil à partir d'un bloc ou de plusieurs blocs d'ancrage.

Selon une autre possibilité de réalisation, la structure suspendue mise en oeuvre à l'aide d'un procédé suivant l'invention, peut être sous forme d'une poutre ou d'un barreau suspendu formant un canal suspendu de transistor par exemple d'un transistor de type VbFET.

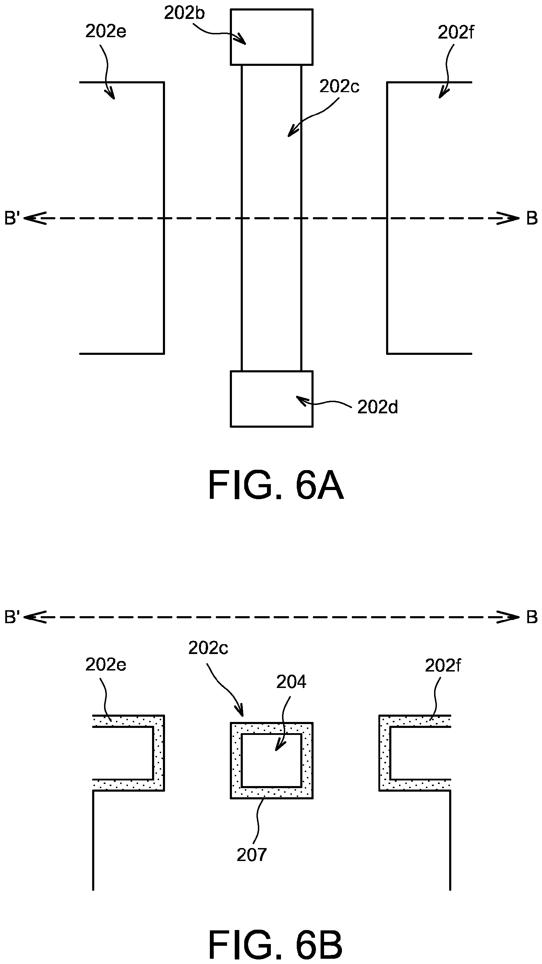

Sur les figures 6A-6B, un exemple de transistor à structure de canal suspendue 202c, mis en oeuvre à l'aide d'un procédé tel que décrit précédemment, et rattaché à des blocs de source 202b, et de drain 202d formant des ancrages, est illustré. Des grilles 202e, 202f sont situés de part et d'autre de la structure suspendue 202c, qui est sous forme d'un barreau semi-conducteur 204 entouré d'une couche de passivation isolante 207, servant de diélectrique de grille (le dispositif étant représenté selon une vue de dessus sur la figure 6A et selon une vue en coupe transversale sur la figure 6B).

## Revendications

1. Procédé de réalisation d'un dispositif microélectronique comprenant, au moins un transistor et au moins un composant, électro-mécanique ou électronique (C) doté d'une structure suspendue, le procédé comprenant les étapes consistant à :
a) former sur une couche de support (101), au moins un élément (104) rattaché à au moins un bloc (102b, 102d) d'ancrage, le bloc d'ancrage ou le bloc d'ancrage et ledit élément étant formés dans au moins une couche mince (102) disposée sur la couche de support (101), ledit élément étant destiné à former ladite structure suspendue (102c) du composant électro-mécanique ou électronique,
b) retrait d'une portion de la couche de support (101) au moins sous ledit élément, de manière à libérer la structure suspendue (104),
c) formation d'une couche de passivation (107), en particulier autour dudit élément,
d) formation d'une couche d' encapsulation (110) recouvrant ladite couche de passivation et ledit élément, la couche d'encapsulation (110) étant à base d'un matériau apte à être gravé de manière sélective vis-à-vis du matériau de la couche de passivation (107),
les couches de passivation (107) et d'encapsulation (110) étant formées de manière à recouvrir la couche mince (102), et le procédé comprenant en outre, après l'étape d), des étapes de :
- retrait de portions de la couche d'encapsulation (110), de manière à dévoiler un motif (102a) de ladite couche mince (102) de zone active dudit transistor,
- formation d'une couche (130) de protection de la couche d'encapsulation (110), ladite couche de protection étant à base d'un matériau destiné à servir d'arrêt de gravure de la couche d'encapsulation (110), ladite couche de protection recouvrant ledit motif (102a) de zone active,
- retrait partiel, de la couche de protection (130) et de la couche de passivation (107), de manière à dévoiler ledit motif (102a) de zone active,
- formation dudit transistor à partir dudit motif de zone active (102a),
- réalisation de zones conductrices (141, 142, 143) de contact et/ou d'interconnexion (M₁, ..., Mₖ), du transistor et du composant puis,
- suppression la couche d'encapsulation (110) autour dudit élément (104) de manière sélective vis-à-vis de la couche de passivation (107), libérant à nouveau ladite structure suspendue.

2. Procédé selon la revendication 1, la couche de passivation étant réalisée par oxydation du matériau semi-conducteur de la couche mince (102).

3. Procédé selon la revendication 1 ou 2, la couche de passivation étant formée par dépôt d'un matériau diélectrique autour de l'élément suspendu.

4. Procédé selon l'une des revendications 1 à 3, la couche d' encapsulation (110) et la couche de support (101) étant à base de matériaux différents.

5. Procédé selon l'une des revendications 1 à 4, dans lequel la couche d' encapsulation (110) est à base de polysilicium ou de silicium amorphe ou SiGe ou Si.

6. Procédé selon la revendication 5, dans lequel la couche de passivation (107) est à base de SiO₂ ou de SiₓN_{y}.

7. Procédé selon l'une des revendications précédentes, dans lequel ledit retrait de portions de la couche d' encapsulation (110) comprend la formation d'une ou plusieurs ouvertures (121b, 121d) au dessus respectivement d'un ou plusieurs blocs d'ancrages (102b, 102d) dudit élément (104), ledit retrait de la couche de protection (130) et de la couche de passivation (107) étant réalisé de manière dévoiler les dits blocs d'ancrages (104).

8. Procédé selon la revendication 7, ladite réalisation de zones conductrices (141, 142, 143ₖ) de contact comprenant : la siliciuration dudit motif de zone active (102a) et desdits blocs d'ancrages (102b, 102d).

9. Procédé selon l'une des revendications précédentes, dans lequel ladite couche mince (102) et la couche de support (101) sont des couches d'un substrat semi-conducteur sur isolant tel qu'un substrat SOI, la couche mince étant semi-conductrice et la couche support étant isolante.

10. Procédé selon l'une des revendications précédentes, dans lequel ladite réalisation de zones conductrices comprend la formation d'un empilement d'un ou plusieurs niveaux métalliques d'interconnexion de composants du dispositif microélectronique et d'une ou plusieurs couches isolantes, ledit empilement recouvrant ledit composant électro-mécanique, le procédé comprenant en outre :
- la formation d'un trou (151) dans ledit empilement en regard de l'élément (104) et dévoilant la couche d'encapsulation (110),
ladite suppression de la couche d'encapsulation (110) autour dudit élément étant réalisée par gravure de la couche d' encapsulation à travers ledit trou (151).

11. Procédé selon la revendication 10, dans lequel la couche de protection et les dites couches isolantes sont à base d'oxyde de silicium, la couche de protection étant supprimée lors de la réalisation du trou.

12. Procédé selon l'une des revendications 1 à 11, ladite suppression de la couche d'encapsulation (110) autour dudit élément (104) étant réalisée par gravure à l'aide de XeF₂.

## Patentansprüche

1. Verfahren zur Herstellung einer mikroelektronischen Vorrichtung umfassend, mindestens einen Transistor und mindestens ein elektromechanisches oder elektronisches Bauteil (C) mit einer hängenden Struktur, wobei das Verfahren die folgenden Schritte umfasst:
a) Ausbilden, auf einer Trägerschicht (101), mindestens eines Elements (104), das mit mindestens einem Verankerungsblock (102b, 102d) verbunden ist, wobei der Verankerungsblock oder der Verankerungsblock und das Element in mindestens einer auf der Trägerschicht (101) angeordneten Dünnschicht (102) ausgebildet sind, wobei das Element zum Ausbilden der hängenden Struktur (102c) des elektromechanischen oder elektronischen Bauteils ausgelegt ist,
b) Abnehmen eines Teils der Trägerschicht (101) mindestens unter dem Element, derart, dass die hängende Struktur (104) freigegeben wird,
c) Bildung einer Passivierungsschicht (107), insbesondere um das Element,
d) Bildung einer Verkapselungsschicht (110), die die Passivierungsschicht und das Element bedeckt, wobei die Verkapselungsschicht (110) auf einem Material basiert, das gegenüber dem Material der Passivierungsschicht (107) selektiv ätzbar ist,
wobei die Passivierungs- (107) und Verkapselungsschichten (110) so ausgebildet sind, dass sie die Dünnschicht (102) bedecken, und das Verfahren ferner, nach Schritt d), die folgenden Schritte umfasst:
- Abnehmen von Teilen der Verkapselungsschicht (110), derart, dass ein Aktivzonenmuster (102a) der Dünnschicht (102) des Transistors enthüllt wird,
- Bildung einer Schutzschicht (130) der Verkapselungsschicht (110), wobei die Schutzschicht auf einem Material basiert, das dazu ausgelegt ist, als Ätzunterbrecher der Verkapselungsschicht (110) zu dienen, wobei die Schutzschicht das Aktivzonenmuster (102a) bedeckt,
- teilweises Abnehmen der Schutzschicht (130) und der Passivierungsschicht (107), derart, dass das Aktivzonenmuster (102a) enthüllt wird,
- Bildung des Transistors aus dem Aktivzonenmuster (102a),
- Herstellung von leitenden Kontakt- und/oder Vernetzungszonen (141, 142, 143) (M₁, ..., Mₖ) des Transistors und des Bauteils, und dann,
- selektive Beseitigung der Verkapselungsschicht (110) um das Element (104) herum gegenüber der Passivierungsschicht (107), wiederum unter Freisetzung der hängenden Struktur.

2. Verfahren nach Anspruch 1, wobei die Passivierungsschicht durch Oxidation des Halbleitermaterials der Dünnschicht (102) hergestellt wird.

3. Verfahren nach Anspruch 1 oder 2, wobei die Passivierungsschicht durch Abscheidung eines dielektrischen Materials um das hängende Element gebildet wird.

4. Verfahren nach einem der Ansprüche 1 bis 3, wobei die Verkapselungsschicht (110) und die Trägerschicht (101) auf unterschiedlichen Materialien basieren.

5. Verfahren nach einem der Ansprüche 1 bis 4, wobei die Verkapselungsschicht (110) auf Polysilicium oder amorphem Silicium oder SiGe oder Si basiert.

6. Verfahren nach Anspruch 5, wobei die Passivierungsschicht (107) auf SiO₂ oder SiₓN_{y} basiert.

7. Verfahren nach einem der vorstehenden Ansprüche, wobei das Abnehmen von Teilen der Verkapselungsschicht (110) die Bildung einer oder mehrerer Öffnungen (121b, 121 d) oberhalb bzw. eines oder mehrerer Verankerungsblöcke (102b, 102d) des Elements (104) umfasst, wobei das Abnehmen der Schutzschicht (130) und der Passivierungsschicht (107) so bewerkstelligt wird, dass die Verankerungsblöcke (104) enthüllt werden.

8. Verfahren nach Anspruch 7, wobei die Herstellung von leitenden Kontaktzonen (141, 142, 143ₖ) Folgendes umfasst: Silizierung des Aktivzonenmusters (102a) und der Verankerungsblöcke (102b, 102d).

9. Verfahren nach einem der vorstehenden Ansprüche, wobei die Dünnschicht (102) und die Trägerschicht (101) Schichten eines Halbleitersubstrats auf Isoliermaterial, wie ein SOI-Substrat, sind, wobei die Dünnschicht halbleitend ist und die Trägerschicht isolierend ist.

10. Verfahren nach einem der vorstehenden Ansprüche, wobei die Herstellung von leitenden Zonen die Bildung eines Stapels von einer oder mehreren metallischen Vernetzungsebenen von Bauteilen der mikroelektronischen Vorrichtung und von einer oder mehreren isolierenden Schichten umfasst, wobei der Stapel das elektromechanische Bauteil bedeckt, wobei das Verfahren ferner Folgendes umfasst:
- Bildung eines Lochs (151) in dem Stapel bezüglich des Elements (104) und Enthüllen der Verkapselungsschicht (110),
wobei die Beseitigung der Verkapselungsschicht (110) um das Element durch Ätzen der Verkapselungsschicht durch das Loch (151) durchgeführt wird.

11. Verfahren nach Anspruch 10, wobei die Schutzschicht und die Isolierschichten auf Siliciumoxid basieren, wobei die Schutzschicht bei der Herstellung des Lochs beseitigt wird.

12. Verfahren nach einem der Ansprüche 1 bis 11, wobei die Beseitigung der Verkapselungsschicht (110) um das Element (104) durch Ätzen mittels XeF₂ bewerkstelligt wird.

## Claims

1. A method for making a microelectronic device comprising at least a transistor and at least an electromechanical component or electronic (C) component provided with a suspended structure, the method comprising the steps of:
a) forming on a supporting layer (101), at least one element (104) bound to at least one anchoring block (102b, 102d) in at least one thin layer (102) positioned on the supporting layer (101), said element being intended to form said suspended structure (102c) of the electromechanical or electronic component,
b) withdrawing a portion of the supporting layer (101) at least under said element, so as to release the suspended structure (104),
c) forming a passivation layer (107) around said element,
d) forming an encapsulation layer (110) covering said passivation layer and said element, the encapsulation layer (110) being based on a material capable of being selectively etched with regard to the material of the passivation layer,
the passivation layer (107) and encapsulation layer (110) being formed so as to cover the thin layer (102), and the method further comprising after step d), steps for:
- withdrawing portions of the encapsulation layer (110), so as to reveal a given area (102a) of said thin layer (102),
- forming a protective layer (130) of the encapsulation layer (110), said protective layer being based on a material provided to stop the etching of the encapsulation (110), said protective layer covering said given area (102a) of said thin layer (102),
- partially withdrawing the protection layer (130) and the passivation layer (107) so as to reveal at least said given area (102a) of said thin layer,
- forming at least one transistor from said given area (102a),
- making contact (141, 142, 143) and/or interconnection conducting areas (M₁, ...Mₖ), and then
- suppressing the encapsulation layer (110) around said element (104) selectively with regard to the passivation layer (107), again releasing said suspended structure.

2. The method according to claim 1, wherein the passivation layer is formed by oxidation of the semiconducting material of said thin layer (102).

3. The method according to any of the claims 1 or 2, the passivation layer being formed by depositing a dielectric material around the suspended element.

4. The method according to any of the claims 1 to 3, the encapsulation layer (110) and the supporting layer (101) being based on different materials.

5. The method according to any of the claims 1 to 4, wherein the encapsulation layer (110) is based on polysilicon or amorphous silicon or SiGe or Si.

6. The method according to claim 5, wherein the passivation layer (107) is based on SiO₂ or SiₓN_{y}.

7. The method according to any of the preceding claims, wherein said withdrawal of portions of the encapsulation layer (110) comprises the formation of one or more apertures (121b, 121d) respectively above one or more anchoring blocks (102b, 102d) of said element (104), said withdrawal of the protection layer (130) and of the passivation layer (107) being carried out so as to reveal said anchoring blocks, the method further comprising the formation of contacts on said anchoring blocks (104).

8. The method according to claim 7, the formation of said contacts (141, 142, 143) comprising: silicidation of said area (102a) and of said anchoring blocks (102b, 102d).

9. The method according to any of the preceding claims, wherein said thin layer (102) and the supporting layer (101) are layers of a semiconductor-on-insulator substrate such as an SOI substrate, the thin layer being semiconducting and the supporting layer being insulating.

10. The method according to any of the preceding claims, wherein said embodiment of conducting areas comprises the formation of a stack of one or more metal levels for interconnecting components of the microelectronic device and of one or more insulating layers, said stack covering said electromechanical component, the method further comprising:
- formation of a hole (151) in said stack facing the element (104) and revealing the encapsulation layer (110),
said suppression of the encapsulation layer (110) around said element being carried out by etching the encapsulation layer through said hole (151).

11. The method according to claim 10, said protecting layer and said insulating layers being based on silicon oxide, the protecting layer being removed when the hole is formed.

12. The method according to any of the claims 1 to 11, said suppression of the encapsulation (110) layer around said element (104) being carried out by etching with XeF₂.
